(19) Europäisches Patentamt
European Patent Office
Office européen des brevets

(11) **EP 4 125 216 A1**

(12) **EUROPEAN PATENT APPLICATION**

(43) Date of publication:
**01.02.2023 Bulletin 2023/05**

(21) Application number: **22187066.0**

(22) Date of filing: **26.07.2022**

(51) International Patent Classification (IPC):
**H03L 7/087** (2006.01)   **H03L 7/089** (2006.01)
**H03L 7/099** (2006.01)   **H03L 7/197** (2006.01)

(52) Cooperative Patent Classification (CPC):
**H03L 7/087; H03L 7/0898; H03L 7/099;
H03L 7/1976;** H03L 2207/06

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**KH MA MD TN**

(30) Priority: **27.07.2021  CN 202110852953**

(71) Applicant: **Silergy Semiconductor Technology
(Hangzhou) Ltd
Zhejiang 310051 (CN)**

(72) Inventors:
• **YE, Yan
  HANGZHOU, 310051 (CN)**
• **LIANG, Cheng
  HANGZHOU, 310051 (CN)**

(74) Representative: **Ström & Gulliksson AB
P.O. Box 793
220 07 Lund (SE)**

(54) **PHASE-LOCKED LOOP CIRCUIT AND METHOD FOR CONTROLLING THE SAME**

(57)     A phase-locked loop circuit and a method for controlling the phase-locked loop circuit are provided. Multiple values of a voltage-controlled oscillator capacitor array control signal respectively corresponding to multiple desired values of a frequency control word signal and multiple values of a charge pump current control signal respectively corresponding to the multiple desired values of the frequency control word signal are acquired in a calibration mode. In a phase-locked mode, a target value of the voltage-controlled oscillator capacitor array control signal corresponding to a target value of the frequency control word signal and a target value of the charge pump current control signal corresponding to the target value of the voltage-controlled oscillator capacitor array control signal are determined based on the data acquired in the calibration mode, to control the phase-locked loop circuit to achieve the phase lock. Therefore, an optimal sub-band is directly determined based on the acquired data, thereby shortening the duration spent by the phase-locked loop circuit on achieving phase lock and reducing power consumption of the phase-locked loop circuit in the process of achieving phase lock.

Figure 1

**EP 4 125 216 A1**

## Description

## FIELD

The present disclosure relates to the technical field of power electronics, and in particular to a phase-locked loop circuit and a method for controlling the phase-locked loop circuit.

## BACKGROUND

In a phase-locked loop (PLL) circuit, a gain KVCO of a voltage-controlled oscillator (VCO) is reduced in order to suppress phase noise generated inside the VCO. The gain KVCO is generally reduced by increasing the number of sub-bands of the VCO, resulting in numerous sub-bands for the VCO. According to the conventional technology, an optimal sub-band is determined by comparing frequency errors of all the sub-bands successively. Therefore, the number of times for comparison is large, resulting in long duration spent by the phase-locked loop circuit on achieve phase lock and high-power consumption of the phase-locked loop circuit in the process of achieving phase lock.

## SUMMARY

In view of this, a phase-locked loop circuit and a method for controlling the phase-locked loop circuit are provided according to embodiments of the present discourse, so as to reduce the duration spent by the phase-locked loop circuit on achieving phase-locked and power consumption of the phase-locked loop circuit in the process of achieving phase-locked.

A method for controlling a phase-locked loop circuit is provided according to a first aspect of the embodiments of the present discourse. The method includes: acquiring multiple of values of a voltage-controlled oscillator capacitor array control signal respectively corresponding to multiple desired values of a frequency control word signal and acquiring multiple values of a charge pump current control signal respectively corresponding to the multiple desired values of the frequency control word signal in a calibration mode, where the frequency control word signal characterizes a ratio of a desired locked frequency to a frequency of a reference signal; and determining a target value of the voltage-controlled oscillator capacitor array control signal corresponding to a target value of the frequency control word signal and a target value of the charge pump current control signal corresponding to the target value of the frequency control word signal in a phase-locked mode, to control the phase-locked loop circuit to achieve phase lock.

In some embodiments, the phase lock is achieved by a voltage-controlled oscillator in the phase-locked loop circuit outputting a frequency signal based on an analog control signal and a digital control signal.

In some embodiments, the voltage-controlled oscillator capacitor array control signal serves as the digital control signal, for controlling total capacitance of a capacitor array in the voltage-controlled oscillator to modify the frequency signal outputted by the voltage-controlled oscillator.

In some embodiments, a bias voltage generated by a bias voltage generation circuit serves as the analog control signal in the calibration mode, and an output signal of a charge pump in the phase-locked loop circuit serves as the analog control signal in the phase-locked mode.

In some embodiments, the method further includes: storing a first correspondence between the frequency control word signal and the voltage-controlled oscillator capacitor array control signal and a second correspondence between the voltage-controlled oscillator capacitor array control signal and the charge pump current control signal in the calibration mode.

In some embodiments, the method further includes: searching the first correspondence for a value of the voltage-controlled oscillator capacitor array control signal corresponding to the target value of the frequency control word signal and determining the found value of the voltage-controlled oscillator capacitor array control signal as the target value of the voltage-controlled oscillator capacitor array control signal in the phase-locked mode.

In some embodiments, the method further includes: searching the second correspondence for a value of the charge pump current control signal corresponding to the target value of the voltage-controlled oscillator capacitor array control signal and determining the found value of the charge pump current control signal as the target value of the charge pump current control signal in the phase-locked mode.

In some embodiments, the acquiring multiple values of a voltage-controlled oscillator capacitor array control signal respectively corresponding to multiple desired values of a frequency control word signal includes: acquiring multiple values of a voltage-controlled oscillator capacitor array control signal respectively corresponding to multiple desired values of a frequency control word signal; determining a theoretical maximum value of the voltage-controlled oscillator capacitor array control signal based on a theoretical maximum value of the frequency control word signal; and acquiring values of the voltage-controlled oscillator capacitor array control signal respectively corresponding to values of the frequency control word signal other than the theoretical minimum value and the theoretical maximum value of the frequency control word signal in a first interval. The first interval is between the theoretical minimum value and the theoretical maximum value of the frequency control word signal, and an interval between the theoretical minimum value and the theoretical maximum value of the voltage-controlled oscillator capacitor array control signal serves as a second interval.

In some embodiments, the determining a theoretical minimum value of the voltage-controlled oscillator capacitor array control signal based on a theoretical minimum value of the frequency control word signal includes: determining a current value of the voltage-controlled oscillator capacitor array control signal; outputting a frequency signal based on a first bias voltage generated by the bias voltage generation circuit and the voltage-controlled oscillator capacitor array control signal; converting the frequency signal into a digital frequency signal based on the reference signal; acquiring a first error based on a difference between the theoretical minimum value of the frequency control word signal and the digital frequency signal; estimating a current conversion gain; determining a second error based on the estimated conversion gain and the first error; determining the current value of the voltage-controlled oscillator capacitor array control signal as the theoretical minimum value of the voltage-controlled oscillator capacitor array control signal and storing the current value of the voltage-controlled oscillator capacitor array control signal in a case that the second error meets a predetermined condition; and modifying the voltage-controlled oscillator capacitor array control signal based on the first error in a case that the second error does not meet the predetermined condition.

In some embodiments, the determining a theoretical maximum value of the voltage-controlled oscillator capacitor array control signal based on a theoretical maximum value of the frequency control word signal includes: determining a current value of the voltage-controlled oscillator capacitor array control signal; outputting the frequency signal based on a first bias voltage generated by the bias voltage generation circuit and the voltage-controlled oscillator capacitor array control signal; converting the frequency signal into a digital frequency signal based on the reference signal; acquiring a first error based on a difference between the theoretical maximum value of the frequency control word signal and the digital frequency signal; estimating a current conversion gain; determining a second error based on the estimated conversion gain and the first error; determining the current value of the voltage-controlled oscillator capacitor array control signal as the theoretical maximum value of the voltage-controlled oscillator capacitor array control signal and storing the current value of the voltage-controlled oscillator capacitor array control signal in a case that the second error meets a predetermined condition; and modifying the voltage-controlled oscillator capacitor array control signal based on the first error in a case that the second error does not meet the predetermined condition.

In some embodiments, the estimating the current conversion gain includes: calculating the conversion gain based on a first difference and a second difference, where the first difference is a difference between a current value of the digital frequency signal and a previous value of the digital frequency signal, and the second difference is a difference between the current value of the voltage-controlled oscillator capacitor array control signal and a previous value of the voltage-controlled oscillator capacitor array control signal.

In some embodiments, the second error is acquired by multiplying a ratio of the first error to the conversion gain by the frequency of the reference signal.

In some embodiments, the predetermined condition is that an absolute value of the second error is less than 1.

In some embodiments, the modifying the voltage-controlled oscillator capacitor array control signal based on the first error includes: superimposing the current value of the voltage-controlled oscillator capacitor array control signal and the second error to obtain a next value of the voltage-controlled oscillator capacitor array control signal until the predetermined condition is met.

In some embodiments, the acquiring values of the voltage-controlled oscillator capacitor array control signal respectively corresponding to values of the frequency control word signal other than the theoretical minimum value and the theoretical maximum value of the frequency control word signal in a first interval includes: selecting a value of the frequency control word signal within the first interval; outputting, for each of values of the voltage-controlled oscillator capacitor array control signal within the second interval, a frequency signal based on the first bias voltage generated by the bias voltage generation circuit and the value of the voltage-controlled oscillator capacitor array control signal; converting each of the outputted frequency signals into a digital frequency signal based on the reference signal; acquiring, for each of the digital frequency signals, a first error of the selected value of the frequency control word signal and the digital frequency signal; and determining a value of the voltage-controlled oscillator capacitor array control signal corresponding to a minimum among the first errors as a value of the voltage-controlled oscillator capacitor array control signal corresponding to the selected value of frequency control word signal, and storing the value of the voltage-controlled oscillator capacitor array control signal corresponding to the selected value of frequency control word signal.

In some embodiments, the acquiring multiple values of a charge pump current control signal respectively corresponding to multiple desired values of the frequency control word signal includes: selecting a value of the voltage-controlled oscillator capacitor array control signal within the second interval; outputting a second frequency signal based on the selected value of the voltage-controlled oscillator capacitor array control signal and a second bias voltage generated by the bias voltage generation circuit; converting the second frequency signal into a second digital frequency signal based on the reference signal; outputting a frequency signal based on the selected value of the voltage-controlled oscillator capacitor array control signal and a third bias voltage generated by the bias voltage generation circuit; converting the frequency signal into a third digital frequency signal based on the reference signal; determining a conversion gain based on the second digital frequency signal and the third digital frequency signal corresponding to the selected value of voltage-controlled oscillator capacitor array control signal; and determining the value of the charge pump current control signal corresponding to the selected value of the voltage-controlled oscillator capacitor array control signal based on the conversion gain, and storing the determined value of the charge pump current control signal.

In some embodiments, the conversion gain is acquired by multiplying a ratio of a third difference to a fourth difference by the frequency of the reference signal. The third difference is a difference between the second digital frequency signal and the third digital frequency signal corresponding to the selected value of the voltage-controlled oscillator capacitor array control signal. The fourth difference is a difference between the second bias voltage and the third bias voltage.

In some embodiments, the charge pump current control signal is used to compensate for a variation in a loop bandwidth resulted from a variation in the conversion gain of the voltage-controlled oscillator with different values of the voltage-controlled oscillator capacitor array control signal, so that the loop bandwidth is constant.

In some embodiments, the method further includes: processing, by a frequency divider, the frequency signal outputted by the voltage-controlled oscillator to acquire a processed signal; outputting a charge pump control signal based on the processed signal and the reference signal, for a charge pump to output the analog control signal based on the target value of the charge pump current control signal and the charge pump control signal; and filtering the analog control signal outputted by the charge pump.

In some embodiments, the method further includes: modifying the voltage-controlled oscillator capacitor array control signal based on the analog control signal; and outputting the modified voltage-controlled oscillator capacitor array control signal to the voltage-controlled oscillator.

In some embodiments, the modifying the voltage-controlled oscillator capacitor array control signal based on the analog control signal includes: comparing the analog control signal outputted by the charge pump with a first threshold and a second threshold, where the first threshold is less than the second threshold; modifying the voltage-controlled oscillator capacitor array control signal in a predetermined direction in response to a comparison result that the analog control signal is less than the first threshold; and modifying the target voltage-controlled oscillator capacitor array control signal in a direction opposite to the predetermined direction in response to a comparison result that the analog control signal is greater than the second threshold.

In some embodiments, a second bias voltage outputted by the bias voltage generation circuit serves as the first threshold, and a third bias voltage outputted by the bias voltage generation circuit serves as the second threshold.

A phase-locked loop circuit is provided according to a second aspect of the embodiments of the present disclosure. The phase-locked loop circuit includes a charge pump, a voltage-controlled oscillator and a calculation storage circuit. The calculation storage circuit is configured to: acquire multiple values of a voltage-controlled oscillator capacitor array control signal respectively corresponding to multiple desired values of a frequency control word signal and acquire multiple values of a charge pump current control signal respectively corresponding to the multiple desired values of the frequency control word signal in a calibration mode, where the frequency control word signal characterizes a ratio of a desired locked frequency to a frequency of a reference signal; and determine a target value of the voltage-controlled oscillator capacitor array control signal corresponding to a target value of the frequency control word signal and a target value of the charge pump current control signal corresponding to the target value of the frequency control word signal in a phase-locked mode, to control the phase-locked loop circuit to achieve phase lock.

In some embodiment, the voltage-controlled oscillator is controlled based on an analog control signal and a digital control signal to, output a frequency signal, so as to achieve phase-locked.

In some embodiments, the voltage-controlled oscillator capacitor array control signal serves as the digital control signal, for controlling total capacitance of a capacitor array in the voltage-controlled oscillator to modify the frequency signal outputted by the voltage-controlled oscillator.

In some embodiments, the phase-locked loop circuit further includes a bias voltage generation circuit. The bias voltage generation circuit is configured to generate a bias voltage as the analog control signal of the voltage-controlled oscillator in the calibration mode. An output signal of the charge pump serves as the analog control signal of the voltage-controlled oscillator in the phase-locked mode.

In some embodiments, the calculation storage circuit is further configured to store a first correspondence between the frequency control word signal and the voltage-controlled oscillator capacitor array control signal and a second correspondence between the voltage-controlled oscillator capacitor array control signal and the charge pump current control signal in the calibration mode.

In some embodiments, the calculation storage circuit is further configured to: search the first correspondence for a value of the voltage-controlled oscillator capacitor array control signal corresponding to the target value of the frequency control word signal; and determine the found value of the voltage-controlled oscillator capacitor array control signal as the target value of the voltage-controlled oscillator capacitor array control signal in the phase-locked mode.

In some embodiments, the calculation storage circuit is further configured to search the second correspondence for a value of the charge pump current control signal corresponding to the target value of the voltage-controlled oscillator capacitor array control signal and determine the found value of the charge pump current control signal as the target value of the charge pump current control signal in the phase-locked mode.

In some embodiments, the calculation storage circuit is configured to, in order to acquire the multiple values of the voltage-controlled oscillator capacitor array control signal respectively corresponding to the multiple desired values of a frequency control word signal: determine a theoretical minimum value of the voltage-controlled oscillator capacitor array control signal based on a theoretical minimum value of the frequency control word signal; determine a theoretical maximum value of the voltage-controlled oscillator capacitor array control signal based on a theoretical maximum value of the frequency control word signal; and acquire values of the voltage-controlled oscillator capacitor array control signal respectively corresponding to values of the frequency control word signal other than the theoretical minimum value and the theoretical maximum value of the frequency control word signal in a first interval, where the first interval is between the theoretical minimum value and the theoretical maximum value of the frequency control word signal, and an interval between the theoretical minimum value and the theoretical maximum value of the voltage-controlled oscillator capacitor array control signal serves as a second interval.

In some embodiments, the phase-locked loop circuit further includes a frequency-to-digital converter. The frequency-to-digital converter is configured to convert, based on the reference signal, the frequency signal outputted by the voltage-controlled oscillator into a digital frequency signal in the calibration mode.

In some embodiments, the calculation storage circuit is configured to, in order to determine the theoretical minimum value of the voltage-controlled oscillator capacitor array control signal: determine a current value of the voltage-controlled oscillator capacitor array control signal; receive the digital frequency signal outputted by the frequency-to-digital converter, where the digital frequency signal is outputted based on the frequency signal outputted by the voltage-controlled oscillator, and the frequency signal is outputted based on a first bias voltage generated by the bias voltage generation circuit and the voltage-controlled oscillator capacitor array control signal; acquire a first error based on a difference between the theoretical minimum value of the frequency control word signal and the digital frequency signal; estimate a current conversion gain; determine a second error based on the estimated conversion gain and the first error; determine the current value of the voltage-controlled oscillator capacitor array control signal as the theoretical minimum value of the voltage-controlled oscillator capacitor array control signal and store the current value of the voltage-controlled oscillator capacitor array control signal in a case that the second error meets a predetermined condition; and modify the voltage-controlled oscillator capacitor array control signal based on the first error in a case that the second error does not meet the predetermined condition.

In some embodiments, the calculation storage circuit is configured to, in order to determine the theoretical maximum value of the voltage-controlled oscillator capacitor array control signal: determine a current value of the voltage-controlled oscillator capacitor array control signal; receive the digital frequency signal outputted by the frequency-to-digital converter, where the digital frequency signal is outputted based on the frequency signal outputted by the voltage-controlled oscillator, and the frequency signal is outputted based on a first bias voltage generated by the bias voltage generation circuit and the voltage-controlled oscillator capacitor array control signal; acquire a first error based on a difference between the theoretical maximum value of the frequency control word signal and the digital frequency signal; estimate a current conversion gain; determine a second error based on the estimated conversion gain and the first error; determine the current value of the voltage-controlled oscillator capacitor array control signal as the theoretical maximum value of the voltage-controlled oscillator capacitor array control signal and store the current value of the voltage-controlled oscillator capacitor array control signal in a case that the second error meets a predetermined condition; and modify the voltage-controlled oscillator capacitor array control signal based on the first error in a case that the second error does not meet the predetermined condition.

In some embodiment, the phase-locked loop circuit further includes a frequency divider, a phase-frequency detector and a filter circuit. The frequency divider is configured to process the frequency signal outputted by the voltage-controlled oscillator to acquire a processed signal. The phase-frequency detector is configured to a charge pump control signal based on the processed signal and the reference signal, for the charge pump to output the analog control signal based on the target value of the charge pump current control signal and the charge pump control signal. The filter circuit is configured to filter the analog control signal outputted by the charge pump.

In some embodiment, the phase-locked loop circuit further includes a locked-phase monitoring circuit. The phase-locked monitoring circuit is configured to: modify the voltage-controlled oscillator capacitor array control signal based on the analog control signal; and output the modified voltage-controlled oscillator capacitor array control signal.

In some embodiment, the phase-locked loop circuit further includes a selection circuit. The selection circuit is configured to: output the voltage-controlled oscillator capacitor array control signal from the calculation storage circuit to the voltage-controlled oscillator, to provide the digital control signal for the voltage-controlled oscillator in the calibration mode; and output the voltage-controlled oscillator capacitor array control signal modified by the phase-locked monitoring circuit to the voltage-controlled oscillator, to provide the digital control signal for the voltage-controlled oscillator in the phase-locked mode.

In the technical solutions of the embodiments of the present disclosure, multiple values of a voltage-controlled oscillator capacitor array control signal respectively corresponding to multiple desired values of a frequency control word signal and multiple values of a charge pump current control signal respectively corresponding to the multiple desired values of the frequency control word signal are acquired in the calibration mode. In the phase-locked mode, a target value of the voltage-controlled oscillator capacitor array control signal corresponding to a target value of the frequency control word signal and a target value of the charge pump current control signal corresponding to the target value of the voltage-controlled oscillator capacitor array control signal are determined based on the data acquired in the calibration mode, to control the phase-locked loop circuit to achieve the phase lock. Therefore, an optimal sub-band is directly determined based on the acquired data, thereby shortening the duration spent by the phase-locked loop circuit on achieving phase lock and reducing power consumption of the phase-locked loop circuit in the process of achieving phase lock.

## BRIEF DESCRIPTION OF THE DRAWINGS

Embodiments of the present disclosure are described below with reference to the drawings, so that the above and other objects, features and advantages of the present disclosure will become clearer. In the drawings:

Figure 1 is a schematic diagram showing a phase-locked loop circuit according to an embodiment of the present disclosure;

Figure 2 is a schematic diagram showing an equivalent circuit of the phase-locked loop circuit according to an embodiment of the present disclosure;

Figure 3 is a flow chart showing determination of a second interval according to an embodiment of the present disclosure;

Figure 4 is a flow chart showing determination of a first correspondence according to an embodiment of the present disclosure;

Figure 5 is a flow chart showing determination of a second correspondence according to an embodiment of the present disclosure;

Figure 6 is a schematic diagram showing another equivalent circuit of the phase-locked loop circuit according to an embodiment of the present disclosure;

Figure 7 is a flow chart showing a phase-locked mode according to an embodiment of the present disclosure; and

Figure 8 is a flow chart showing a method for controlling the phase-locked loop circuit according to an embodiment of the present disclosure.

## DETAILED DESCRIPTION OF EMBODIMENTS

The present disclosure is described below based on embodiments. However, the present disclosure is not limited to these embodiments. In the detailed description of the present disclosure hereinafter, some specific details are described. Those skilled in the art can completely understand the present disclosure without the description of the details. In order to avoid obscuring the substance of the present disclosure, well-known methods, procedures, processes, elements and circuits are not described in detail.

In addition, those skilled in the art should understand that the drawings are provided herein for illustration, and are unnecessarily drawn to scale.

In addition, it should be understood that in the following description, the term "circuit" indicates a loop that conducts electricity and is formed by at least one element or sub-circuit through electrical connection or electromagnetic connection. In a case that an element or circuit is described as "connected to" another element or in a case that an element or circuit is described as "connected" between two nodes, the element or circuit may be directly coupled or connected to another element, or there is other element between the element or circuit and another element. The connection between elements may be physical, logical, or a combination thereof. In contrast, in a case that an element is described as "directly coupled" or "directly connected" to another element, there is no element between the element and another element.

Unless explicitly indicated herein, the words "including", "comprising" and the like in the specification should be interpreted as inclusive rather than exclusive or exhaustive, that is, "including but not limited to".

In the description of the present disclosure, it should be understood that the terms "first", "second" and the like are only for illustrative rather than indicating or implying relative importance. In addition, in the description of the present disclosure, the term "multiple" or "a plurality of" indicates two or more unless otherwise specified.

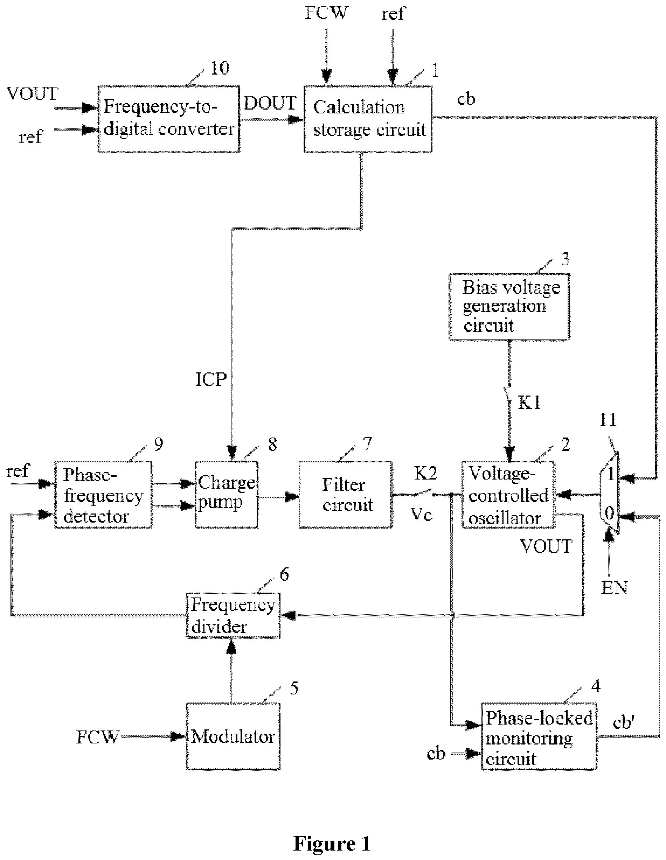

Figure 1 is a schematic diagram showing a phase-locked loop circuit according to an embodiment of the present disclosure. As shown in Figure 1, the phase-locked loop circuit according to the embodiment of the present disclosure includes a calculation storage circuit 1, a voltage-controlled oscillator 2, a bias voltage generation circuit 3, a phase-locked monitoring circuit 4, a modulator 5, a frequency divider 6, a filter circuit 7, a charge pump 8, a phase-frequency detector 9, a frequency-to-digital converter 10, a selection circuit 11, a first switch K1 and a second switch K2.

In the embodiment, on-off states of the first switch K1 and the second switch K2 are controlled, so that the phase-locked loop circuit operates in different modes, including a calibration mode and a phase-locked mode. In the calibration mode, the phase-locked loop circuit determines, for each desired value of a frequency control word signal, a value of a voltage-controlled oscillator capacitor array control signal corresponding to the desired value of the frequency control word signal, where the voltage-controlled oscillator capacitor array control signal is used for controlling a capacitor array in the voltage-controlled oscillator; and determines, for each desired value of the frequency control word signal, a value of a charge pump current control signal corresponding to the desired value of the frequency control word signal, where the charge pump current control signal characterizes an desired current of the charge pump. The frequency control word signal refers to a ratio of a desired locked frequency to a frequency of a reference signal. In the phase-locked mode, a value of the voltage-controlled oscillator capacitor array control signal corresponding to a target value of the frequency control word signal is directly read to control total capacitance of the capacitor array in the voltage-controlled oscillator, and a value of the charge pump current control signal corresponding to the target value of the frequency control word signal is directly read to modify an output signal of the charge pump, thereby achieving phase lock while a control voltage of the voltage-controlled oscillator is within an operation range. In this way, duration spent by the phase-locked loop circuit on achieving phase lock can be reduced. The phase-locked loop circuit is further described below in conjunction with respective flows of modes.

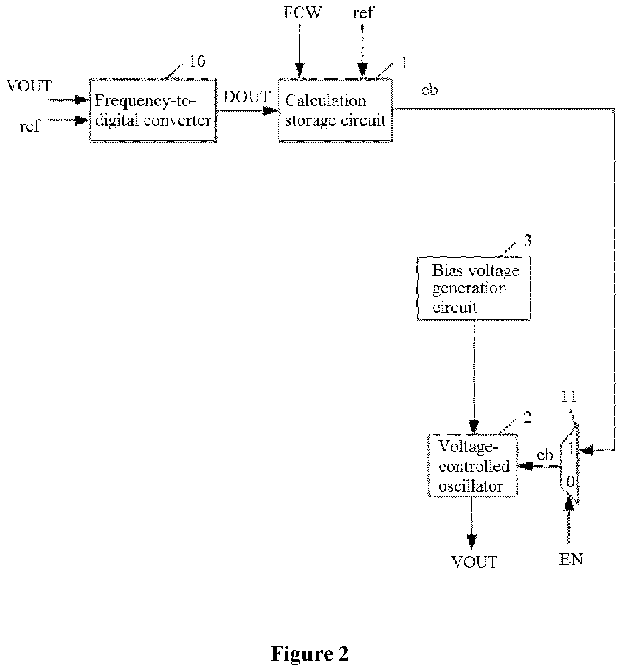

Further, the first switch K1 is controlled to be on and the second switch K2 is controlled to be off, so that the phase-locked loop circuit operates in the calibration mode. In such case, an equivalent circuit of the phase-locked loop circuit is shown in Figure 2.

In the embodiment, the bias voltage generation circuit 3 may generate at least three voltages including a low voltage VL, a high voltage VH and a medium voltage VM. The medium voltage VM is less than the high voltage VH and greater than the low voltage VL. In an embodiment, the medium voltage VM is equal to a half of a power supply voltage VDD of the bias voltage generation circuit 3. In the embodiment, the medium voltage VM, the low voltage VL and the high voltage VH are described as a first bias voltage, a second bias voltage and a third bias voltage, respectively.

In the embodiment, the voltage-controlled oscillator 2 includes an analog signal receiving terminal and a digital signal receiving terminal. The voltage-controlled oscillator 2 receives an analog control signal via the analog signal receiving terminal and receives a digital control signal via the digital signal receiving terminal, and outputs a frequency signal VOUT based on the analog control signal and the digital control signal. The frequency signal VOUT is an output signal of the phase-locked loop circuit.

The analog control signal serves as a control voltage for the voltage-controlled oscillator 2, to modify a frequency of a signal outputted by the voltage-controlled oscillator 2. The total capacitance of the capacitor array in the voltage-controlled oscillator 2 is controlled based on the digital control signal, so as to modify a range of the frequency of the signal outputted by the voltage-controlled oscillator 2. That is, the frequency signal VOUT outputted by the voltage-controlled oscillator 2 is controlled based on both the analog control signal and the digital control signal. The voltage-controlled oscillator capacitor array control signal serves as the digital control signal, and the voltage control signal of the voltage-controlled oscillator serves as the analog control signal.

Further, in the calibration mode as shown in Figure 2, the analog control signal received by the analog signal receiving terminal is an output signal of the bias voltage generation circuit 3. The digital signal receiving terminal is connected to an output terminal of the selection circuit 11, and is configured to receive the digital control signal outputted by the selection circuit 11.

In the embodiment, the selection circuit 11 has an enable terminal, a first input terminal and a second input terminal. The enable terminal is configured to receive an enable signal EN. The first input terminal is connected to an output terminal of the calculation storage circuit 1, and is configured to receive a first voltage-controlled oscillator capacitor array control signal cb outputted by the calculation storage circuit 1. The second input terminal is configured to receive a second voltage-controlled oscillator capacitor array control signal cb' outputted by the phase-locked monitoring circuit 4. The selection circuit 11 selects one of the signals cb and cb', and outputs the selected signal to the voltage-controlled oscillator 2, to control the total capacitance of the capacitor array in the voltage-controlled oscillator 2. That is, the voltage-controlled oscillator capacitor array control signal serves as the digital control signal. For example, in a case that the enable signal EN is in a first state, the first voltage-controlled oscillator capacitor array control signal cb is selected, and is outputted to the voltage-controlled oscillator 2, as shown in Figure 2.

In some embodiments, the first state indicates a high level. That is, in a case that the enable signal EN is at a high level, the voltage-controlled oscillator capacitor array control signal cb is outputted to the voltage-controlled oscillator 2.

In the embodiment, the calculation storage circuit 1 receives a reference signal ref, a frequency control word signal FCW and a digital frequency signal DOUT outputted by the frequency-to-digital converter 10, and outputs the voltage-controlled oscillator capacitor array control signal cb based on the reference signal ref, the frequency control word signal FCW and the digital frequency signal DOUT. The frequency control word signal FCW characterizes a ratio (represented in binary) of the desired locked frequency to a frequency of the reference signal ref. The digital frequency signal DOUT characterizes a ratio (represented in binary) of a frequency of the frequency signal VOUT outputted by the phase-locked loop circuit to the frequency of the reference signal ref. It should be understood that the frequency control word signal FCW and the digital frequency signal DOUT each may include an integer part and a decimal part.

In the embodiment, the frequency-to-digital converter 10 receives the frequency signal VOUT outputted by the voltage-controlled oscillator 2 and the reference signal ref, calculates the digital frequency signal DOUT based on the frequency signal VOUT and the reference signal ref, and outputs the digital frequency signal DOUT to the calculation storage circuit 1.

Further, the calibration mode may include two stages. In a first stage, the phase-locked loop circuit acquires, for each value of the frequency control word signal FCW, a value of the voltage-controlled oscillator capacitor array control signal cb corresponding to the value of the frequency control word signal FCW. In a second stage, the phase-locked loop circuit acquires, for each value of the voltage-controlled oscillator capacitor array control signal cb, a value of the charge pump current control signal ICP corresponding to the value of the voltage-controlled oscillator capacitor array control signal cb. The charge pump current control signal ICP is used to compensate for a variation in a loop bandwidth resulted from a variation in the gain KVCO of the voltage-controlled oscillator 2 with different values of the voltage-controlled oscillator capacitor array control signal cb, so that the loop bandwidth is constant.

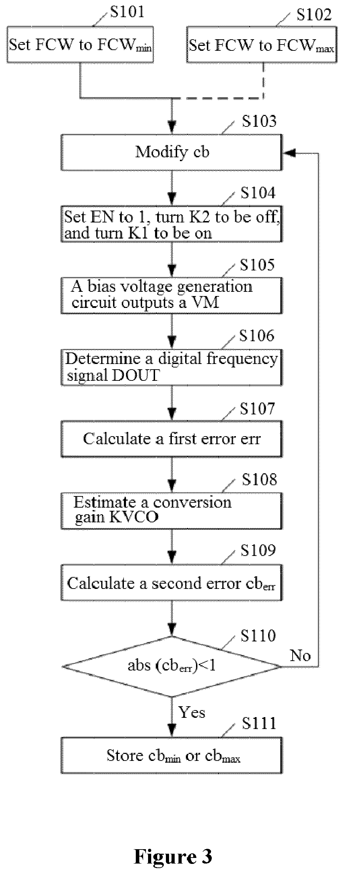

Further, in the first stage, the phase-locked loop circuit first acquires a second interval characterizing a range of the voltage-controlled oscillator capacitor array control signal cb. That is, the phase-locked loop circuit first determines a theoretical minimum value and a theoretical maximum value of the voltage-controlled oscillator capacitor array control signal cb respectively corresponding to a minimum value $FCW_{min}$ and a maximum value $FCW_{max}$ of the frequency control word signal FCW. Figure 3 shows a flow chart of operation of the phase-locked loop circuit. Reference is made to Figures 2 and 3. The theoretical minimum value of the voltage-controlled oscillator capacitor array control signal cb is acquired by performing step S101 and steps S103 to S111. The theoretical maximum value of the voltage-controlled oscillator capacitor array control signal cb is acquired by performing steps S102 to S111. Therefore, the second interval is acquired. The second interval is between the theoretical minimum value and the theoretical maximum value of the voltage-controlled oscillator capacitor array control signal cb.

The phase-locked loop circuit acquires the theoretical minimum value of the voltage-controlled oscillator capacitor array control signal cb by performing the following step S101, and steps S103 to S111.

In step S101, the frequency control word signal FCW is set to the minimum value $FCW_{min}$.

The calculation storage circuit 1 acquires a first interval. The first interval is between a theoretical minimum value and a theoretical maximum value of the frequency control word signal FCW. The theoretical minimum value and the theoretical maximum value of the frequency control word signal FCW are determined based on a range of the desired locked frequency. It should be understood that the range of the desired locked frequency depends on the actual application scenario. The range of the desired locked frequency varies from actual application scenario to actual application scenario. For example, the range of the desired locked frequency may be described as $[F_{min}, F_{max}]$. $F_{min}$ represents a minimum of the desired locked frequency in an application scenario, and $F_{max}$ represents a maximum of the desired locked frequency in the application scenario. The theoretical minimum value $FCW_{min}$ of the frequency control word signal corresponding to the minimum $F_{min}$ of the desired locked frequency is acquired, and the theoretical maximum value $FCW_{max}$ of the frequency control word signal corresponding to the maximum $F_{max}$ of the desired locked frequency is acquired. The frequency control word signal characterizes the ratio of the desired locked frequency F to the frequency of the reference signal ref. Therefore, the first interval $[FCWmin, FCW_{max}]$ is acquired.

In step S103, the voltage-controlled oscillator capacitor array control signal cb is modified.

At the beginning, the voltage-controlled oscillator capacitor array control signal cb is set to an initial value. The value of the voltage-controlled oscillator capacitor array control signal cb has an effective range depending on a structure of the voltage-controlled oscillator 2, and the voltage-controlled oscillator 2 can be effectively controlled with cb being set to any value within the effective range. The initial value is any value within the effective range. Preferably, the initial value is equal to a half of a maximum in the effective range, so that none of the number of times for increasing cb from the initial value and the number of times for decreasing cb from the initial value is too large. For example, it is assumed that the capacitor array has 5 bits, the value of cb is 32 at most, and the initial value may be 16.

In step S104, enable signal EN is set to 1, K2 is turned off and K1 is turned on.

Enable signal EN is set to 1, that is, enable signal EN is at a high level, so that the selection circuit 11 selects the voltage-controlled oscillator capacitor array control signal cb outputted by the calculation storage circuit 1 and outputs the voltage-controlled oscillator capacitor array control signal cb. In Figure 2, numbers 0 and 1 in the selection circuit 11 represent pins of the selection circuit 11.

The second switch K2 is off and the first switch K1 is on, so that the phase-locked loop circuit operates in the mode shown in Figure 2.

In step S105, the bias voltage generation circuit outputs the medium voltage VM

The voltage outputted by the bias voltage generation circuit 3 is the medium voltage VM

It should be understood that the circuit is configured by performing the steps S101 and S103 to S105. The steps S101 and S103 to S105 may be performed sequentially or performed simultaneously rather than in a limited order.

In step S106, the digital frequency signal DOUT is determined.

The calculation storage circuit 1 outputs the initial value of the voltage-controlled oscillator capacitor array control signal cb to the voltage-controlled oscillator 2, so that the voltage-controlled oscillator 2 outputs the frequency signal VOUT based on the first bias voltage VM and the initial value of the voltage-controlled oscillator capacitor array control signal cb. The frequency-to-digital converter 10 converts the frequency signal VOUT into the digital frequency signal DOUT based on the reference signal ref.

Further, the reference signal ref is a clock signal, and a frequency and a cycle of the reference signal ref are known. Therefore, the number of cycles of the frequency signal VOUT may be calculated within a predetermined number of cycles of the reference signal, to acquire the digital frequency signal DOUT. For example, assuming that the number of the cycles of the frequency signal VOUT is M within N cycles of the reference signal, the digital frequency signal DOUT is equal to M divided by N. In this way, the digital frequency signal DOUT is determined.

In step S107, a first error err is calculated.

A difference between the minimum value $FCW_{min}$ of the frequency control word signal and a value of the digital frequency signal DOUT is calculated, and the difference is determined as the first error err, that is, err=FCWmin-DOUT.

In step S108, a conversion gain KVCO is estimated.

The conversion gain KVCO is estimated from the following equation:

$$KVCO = \frac{DOUT_1 - DOUT_2}{cb_1 - cb_2} * Fref$$

KVCO represents the conversion gain. $DOUT_1$ represents a previous value of the digital frequency signal. $DOUT_2$ represents a next value of the digital frequency signal. $cb_1$ represents a previous value of the voltage-controlled oscillator capacitor array control signal. $cb_2$ represents a current value of the voltage-controlled oscillator capacitor array control signal. Fref represents the frequency of the reference signal ref.

Further, the conversion gain characterizes a variation in the frequency of the frequency signal VOUT with the voltage-controlled oscillator capacitor array control signal cb changing by one unit (that is equal to 1 herein).

In the first calculation, there is no cb1 and $DOUT_1$, and thus the conversion gain is set to a preset value.

In step S109, a second error $cb_{err}$ is calculated.

The second error $cb_{err}$ is calculated based on the conversion gain KVCO and the first error err. The second error $cb_{err}$ represents a difference between a current value of the voltage-controlled oscillator capacitor array control signal cb and a target value of the voltage-controlled oscillator capacitor array control signal cb. The second error $cb_{err}$ is calculated from the following equation:

$$cb_{err} = \frac{err * Fref}{KVCO}$$

err represents the first error, Fref represents the frequency of the reference signal, and KVCO represents the conversion gain.

In step S110, it is determined whether an absolute value of the second error is less than 1.

It is determined whether the absolute value abs ($cb_{err}$) of the second error is less than 1.

In step S111, in response to a determination result that the absolute value abs ($cb_{err}$) of the second error is less than 1, the current value of cb is recoded as $cb_{min}$.

In response to a determination result that the absolute value abs ($cb_{err}$) of the second error is not less than 1, the process returns to step S103. The voltage-controlled oscillator capacitor array control signal cb is set to a new value, which is equal to a sum of the current value of the voltage-controlled oscillator capacitor array control signal cb and $cb_{err}$. Then, steps S104 to S110 are performed until the absolute value abs ($cb_{err}$) of the second error is less than 1. Step S111 is performed, that is, the new value of the second error cb is recorded as $cb_{min}$.

Similarly, the frequency control word signal FCW is set to the maximum value $FCW_{max}$ (that is, step S102 is performed), and thus $cb_{max}$ is acquired from step S111.

Therefore, the second interval is acquired, and is between $cb_{min}$ and $cb_{max}$.

In some embodiments, the acquired $cb_{min}$ and $cb_{max}$ may further be extended to acquire a wider second interval. For example, the second interval may be (cbmin-1, $cb_{max}$+1).

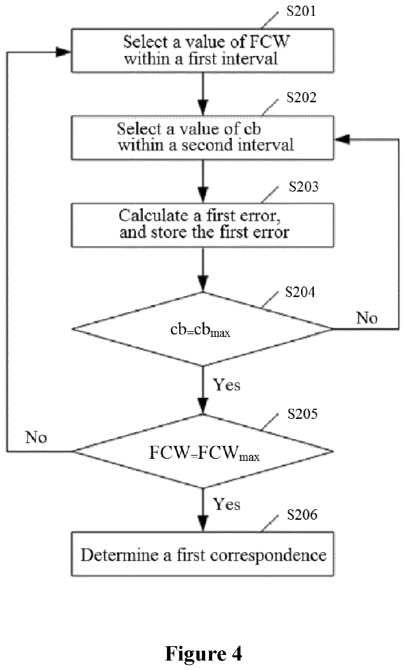

Further, the phase-locked loop circuit acquires, for each of other values of the frequency control word signal FCW within the first interval, a value of the voltage-controlled oscillator capacitor array control signal cb corresponding to the value of the frequency control word signal FCW, so as to acquire values of the voltage-controlled oscillator capacitor array control signal cb respectively corresponding to all values of the frequency control word signal FCW within the first interval. In this case, the phase-locked loop circuit acquires the values of the voltage-controlled oscillator capacitor array control signal cb by performing the following steps S201 to S206, as shown in Figure 4.

In step S201, a value of the frequency control word signal FCW other than $FCW_{min}$ and $FCW_{max}$ within the first interval is selected.

For example, the first interval [$FCW_{min}$, $FCW_{max}$] indicates n frequency control word signals, and the n frequency control word signals are $FCW_1$, $FCW_2$,..., $FCW_n$ in ascending order. $FCW_1$ is set to the minimum value $FCW_{min}$, and FCWn is set to the maximum value $FCW_{max}$. A frequency control word signal FCWi within the first interval is selected in a predetermined order, where i = 2,..., n-1, and n is greater than 1. It should be understood that a step size for FCW depending on the actual application. For example, frequency channels vary from transceiver to transceiver, and thus a value of n varies from transceiver to transceiver. In the embodiment shown in Figure 4, values of the frequency control word signal FCWi within the first interval is selected in ascending order. That is, the frequency control word signal $FCW_2$ is selected at the beginning.

In step S202, a value of the voltage-controlled oscillator capacitor array control signal cb rather than $cb_{min}$ and $cb_{max}$ within the second interval is selected.

The value of the voltage-controlled oscillator capacitor array control signal cb within the second interval is selected.

For example, the second interval [$cb_{min}$, $cb_{max}$] indicats m voltage-controlled oscillator capacitor array control signals cb, and the m voltage-controlled oscillator capacitor array control signals are $cb_i$, $cb_2$,..., $cb_m$ in ascending order. $cb_1$ is set to $cb_{min}$, and $cb_m$ is set to $cb_{max}$. A voltage-controlled oscillator capacitor array control signal within the second interval $cb_j$ is selected in a predetermined order, where j = 2,..., m-1, and m is greater than 1. In the embodiment shown in Figure 4, the voltage-controlled oscillator capacitor array control signal $cb_j$ within the second interval is selected in ascending order. That is, the voltage-controlled oscillator capacitor array control signal $cb_2$ is selected at the beginning.

In step S203, a first error is calculated and stored.

A digital frequency signal $DOUT_j$ corresponding to the selected voltage-controlled oscillator capacitor array control signal $cb_j$ is acquired. The voltage-controlled oscillator 2 generates the frequency signal $VOUT_j$ based on the selected voltage-controlled oscillator capacitor array control signal $cb_j$ and the first bias voltage VM. The frequency-to-digital converter 10 outputs the digital frequency signal $DOUT_j$ based on the frequency signal $VOUT_j$. A difference between the selected frequency control word signal FCWi and the digital frequency signal $DOUT_j$ is acquired as the first error $err_{i,j}$. The first error is calculated by performing steps S106 and S107 shown in Figure 3, and further details are not repeated in the embodiment of the present disclosure.

In step S204, it is determined whether a current value of the voltage-controlled oscillator capacitor array control signal cb is equal to $cb_{max}$.

It is determined whether the current value of the voltage-controlled oscillator capacitor array control signal cb is equal to $cb_{max}$. If it is determined that the current value of cb is equal to $cb_{max}$, step S205 is performed.

It is determined whether the current value of cb is equal to $cb_{max}$. If it is determined that the current value of cb is not equal to $cb_{max}$, the process returns to step S202, that is, cb is set to a next value, until a current value of cb is equal to $cb_{max}$, and step S205 is performed.

In step S205, it is determined whether the current value of FCW is equal to $FCW_{max}$.

It is determined whether the current value of FCW is equal to $FCW_{max}$. If it is determined that the current value of FCW is equal to $FCW_{max}$, step S206 is performed.

It is determined whether the current value of FCW is equal to $FCW_{max}$. If it is determined that the current value of FCW not equal to $FCW_{max}$, the process returns to step S201, that is, FCW is set to a next value, until a current value of FCW is equal to $FCW_{max}$, and S206 is performed. It should be understood that step S204 may be performed after step S205.

In step S206, a first correspondence is determined.

The first error $err_{i,j}$ as the difference between the frequency control word signal FCWi and the voltage-controlled oscillator capacitor array control signal $cb_j$ is acquired from the steps S201 to S205. A voltage-controlled oscillator capacitor array control signal corresponding to a first error with a minimum absolute value is determined as corresponding to the selected frequency control word signal FCWi, and is stored.

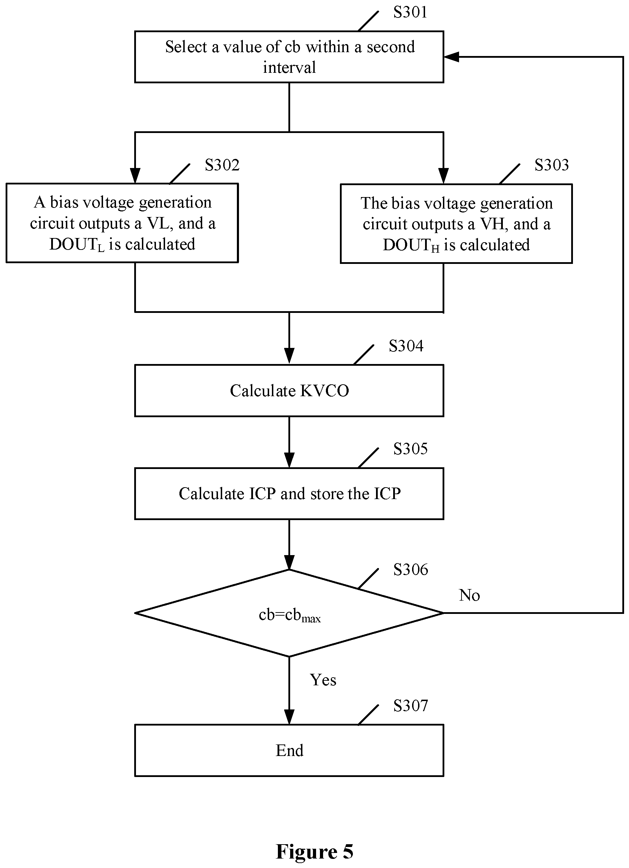

Further, those skilled in the art should know that the loop bandwidth of the phase-locked loop circuit depends on a charge pump current I_cp in the charge pump 8, the conversion gain KVCO and the frequency control word signal FCW. It is necessary to compensate for the charge pump current, to keep I_cp×Kvco/FCW constant, such that the loop bandwidth of the phase-locked loop circuit is constant under different values of the voltage-controlled oscillator capacitor array control signal cb. In the second stage, the phase-locked loop circuit acquires, for each value of the voltage-controlled oscillator capacitor array control signal cb, a value of the charge pump current control signal ICP corresponding to the value of the voltage-controlled oscillator capacitor array control signal cb. The charge pump current control signal ICP characterizes a desired value of the charge pump current I_cp in the charge pump 8. That is, the charge pump 8 modifies the charge pump current I_cp based on the charge pump current control signal ICP, so that the charge pump current I_cp is equal to a value of the charge pump current control signal ICP. The phase-locked loop circuit acquires the charge pump current control signal ICP corresponding to the voltage-controlled oscillator capacitor array control signal cb by performing the following steps S301 to S307, as shown in Figure 5.

In step S301, a value of the voltage-controlled oscillator capacitor array control signal cb within the second interval is selected.

The value of the voltage-controlled oscillator capacitor array control signal cb within the second interval is selected.

For example, the second interval [cbmin, $cb_{max}$] indicates m voltage-controlled oscillator capacitor array control signals cb, and the m voltage-controlled oscillator capacitor array control signals are cbi, $cb_2$,..., $cb_m$ in ascending order. $cb_1$ is set to $cb_{min}$, and $cb_m$ is set to $cb_{max}$. A voltage-controlled oscillator capacitor array control signal $cb_j$ within the second interval is selected in a predetermined order, where j = 1, 2,..., m. In the embodiment shown in Figure 5, the voltage-controlled oscillator capacitor array control signal $cb_j$ within the second interval is selected in ascending order. That is, the voltage-controlled oscillator capacitor array control signal $cb_1$ is selected at the beginning.

In step S302, the bias voltage generation circuit outputs the second bias voltage VL, and a digital frequency signal $DOUT_L$ is calculated.

The bias voltage generation circuit 3 is controlled to output the second bias voltage VL, and the digital frequency signal $DOUT_L$ corresponding to the selected voltage-controlled oscillator capacitor array control signal $cb_j$ and the second bias voltage VL is acquired. The voltage-controlled oscillator 2 generates the frequency signal VOUT based on the selected voltage-controlled oscillator capacitor array control signal $cb_j$ and the second bias voltage VL. The frequency digital converter 10 outputs the digital frequency signal $DOUT_L$ based on the frequency signal.

In step S303, the bias voltage generation circuit outputs the third bias voltage VH, and a digital frequency signal $DOUT_H$ is calculated.

The bias voltage generation circuit 3 is controlled to output the third bias voltage VH, and the digital frequency signal $DOUT_H$ corresponding to the selected voltage-controlled oscillator capacitor array control signal $cb_j$ and the third bias voltage VH is acquired. The voltage-controlled oscillator 2 generates the frequency signal based on the selected voltage-controlled oscillator capacitor array control signal $cb_j$ and the third bias voltage VH The frequency digital converter 10 outputs the digital frequency signal $DOUT_H$ based on the frequency signal.

It should be understood that the steps S302 and S303 may be performed one after another or in parallel.

In step S304, the conversion gain KVCO is calculated.

The conversion gain KVCO is calculated based on the digital frequency signals $DOUT_L$ and $DOUT_H$ from the following equation:

$$KVCO = \frac{DOUT_L - DOUT_H}{VL - VH} * Fref$$

$DOUT_L$ represents the digital frequency signal corresponding to the second bias voltage VL outputted by the bias voltage generation circuit 3. $DOUT_H$ represents the digital frequency signal corresponding to the third bias voltage VH outputted by the bias voltage generation circuit 3. VL represents the second bias voltage. VH represents the third bias voltage. Fref represents the frequency of the reference signal ref.

In step S305, the charge pump current control signal ICP is calculated.

The charge pump current control signal ICP is calculated based on the conversion gain KVCO from the following equation:

$$ICP = \frac{KVCO_{init}}{KVCO} * \frac{FCW}{FCW_{init}} * ICP_{init}$$

KVCO represents the conversion gain. $KVCO_{init}$ represents an initial value of the conversion gain. FCW represents the frequency control word signal corresponding to the selected voltage-controlled oscillator capacitor array control signal $cb_j$. $FCW_{init}$ represents an initial value of the frequency control word signal. ICP represents the charge pump current control signal and represents a desired value of the charge pump current, and $ICP_{init}$ represents an initial value of the charge pump current.

Therefore, the charge pump current control signal ICP corresponding to the selected voltage-controlled oscillator capacitor array control signal cb is acquired and stored.

In step S306, it is determined whether the value of cb is equal to $cb_{max}$.

It is determined whether a current value of cb is equal to $cb_{max}$. If it is determined that the current value of cb is equal to $cb_{max}$, step S307 is performed.

It is determined whether the current value of cb is equal to $cb_{max}$. If it is determined that the current value of cb is not equal to $cb_{max}$, the process returns to step 301, that is, cb is set to another value until a current value of cb is equal to $cb_{max}$, and step S307 is performed.

In step S307, the process of acquiring the charge pump current control signal ICP ends.

Therefore, values of the charge pump current control signal ICP respectively corresponding to all values of the voltage-controlled oscillator capacitor array control signal cb are acquired.

In summary, in the calibration mode, the phase-locked loop circuit acquires the voltage-controlled oscillator capacitor array control signal cb corresponding to the frequency control word signal FCW and store the acquired voltage-controlled oscillator capacitor array control signal cb. The phase-locked loop circuit further acquires the charge pump current control signal ICP corresponding to the voltage-controlled oscillator capacitor array control signal cb, and stores the acquired charge pump current control signal ICP. In the phase-locked mode, for a desired locked frequency, a value of the voltage-controlled oscillator capacitor array control signal cb and a value of the charge pump current control signal ICP are directly determined based on the stored data, to rapidly achieve phase lock. In addition, in a case that the control voltage of the voltage-controlled oscillator is controlled outside the operation range based on the selected voltage-controlled oscillator capacitor array control signal cb, the voltage-controlled oscillator capacitor array control signal cb is slightly modified, to make the control voltage of the voltage-controlled oscillator within the operation range, so as to achieve phase lock.

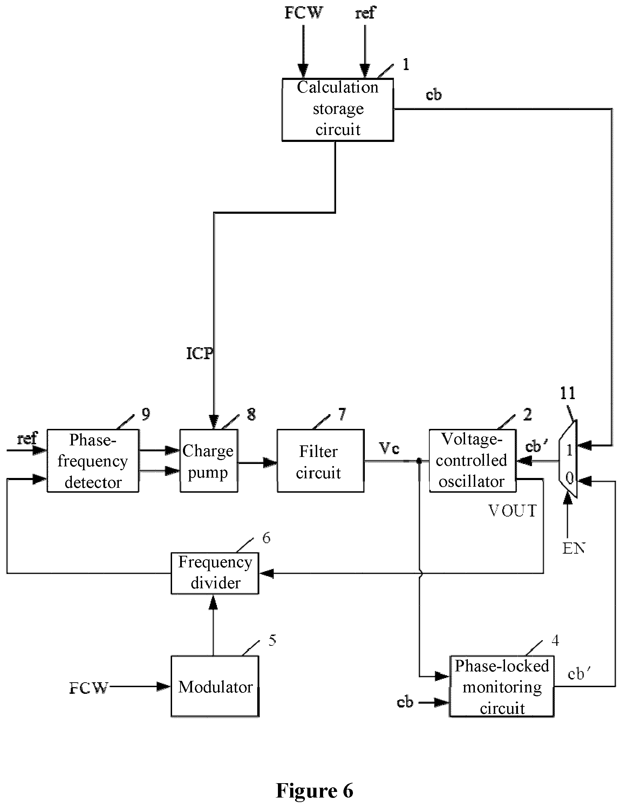

Further, in the phase-locked mode, the switch K2 is on and the switch K1 is off. In such case, an equivalent circuit of the phase-locked loop circuit is shown in Figure 6.

In the embodiment, the voltage-controlled oscillator 2 has an analog signal receiving terminal and a digital signal receiving terminal. The voltage-controlled oscillator 2 receives an analog control signal via the analog signal receiving terminal and receives a digital control signal via the digital signal receiving terminal, and outputs a frequency signal VOUT based on the analog control signal and the digital control signal.

Further, the analog control signal received via the analog signal receiving terminal is an output signal of the charge pump 8, specifically a signal outputted from the filter circuit 7 after processing the output signal of the charge pump 8. The digital signal receiving terminal is connected to the output terminal of the selection circuit 11, and is configured to receive the digital control signal outputted by the selection circuit 11.

In the embodiment, the selection circuit 11 has an enable terminal, a first input terminal and a second input terminal. The enable terminal is configured to receive an enable signal EN. The first input terminal is connected to an output terminal of the calculation storage circuit 1, and is configured to receive a voltage-controlled oscillator capacitor array control signal cb outputted by the calculation storage circuit 1. The second input terminal is configured to receive a voltage-controlled oscillator capacitor array control signal cb' outputted by the phase-locked monitoring circuit 4. The selection circuit 11 selects one of the signals cb and cb', and outputs the selected signal to the voltage-controlled oscillator 2. That is, the voltage-controlled oscillator capacitor array control signal serves as the digital control signal. For example, in a case that the enable signal EN is in a first state, the voltage-controlled oscillator capacitor array control signal cb is selected, and is outputted to the voltage-controlled oscillator 2. In a case that the enable signal EN is in a second state, the voltage-controlled oscillator capacitor array control signal cb' is selected and is outputted to the voltage-controlled oscillator 2. In the embodiment, the enable signal EN is in the second state, that is, the voltage-controlled oscillator 2 receives the voltage-controlled oscillator capacitor array control signal cb'.

In some embodiments, the second state indicates a low level. That is, in a case that the enable signal EN is at a low level, the voltage-controlled oscillator capacitor array control signal cb' is outputted to the voltage-controlled oscillator 2.

In some embodiments, the calculation storage circuit 1 receives a target frequency control word signal FCW.

The calculation storage circuit 1 acquires stored data. The stored data includes a first correspondence between the frequency control word signal FCW and the voltage-controlled oscillator capacitor array control signal cb, and a second correspondence between the voltage-controlled oscillator capacitor array control signal cb and the charge pump current control signal ICP. The first correspondence is searched for a voltage-controlled oscillator capacitor array control signal cb corresponding to a target frequency control word signal, and the found voltage-controlled oscillator capacitor array control signal cb is determined as a target voltage-controlled oscillator capacitor array control signal. The second correspondence is searched for a charge pump current control signal corresponding to the target voltage-controlled oscillator capacitor array control signal, and the found charge pump current control signal is determined as a target charge pump current control signal. The target voltage-controlled oscillator capacitor array control signal is outputted to the phase-locked monitoring circuit 4, and the target charge pump current control signal is outputted to the charge pump 8.

The charge pump 8 receives an output signal of the phase-frequency detector 9 and the target charge pump current control signal, and outputs a voltage signal based on the output signal of the phase-frequency detector 9 and the target charge pump current control signal. The voltage signal is processed by the filter circuit 7, and the processed voltage signal serves as an analog control signal and is outputted to the analog signal receiving terminal of the voltage-controlled oscillator 2. The analog control signal outputted by the filter circuit 7 is represented by Vc.

The phase-locked monitoring circuit 4 is configured to determine whether the control voltage of the voltage-controlled oscillator 2 is outside the operation range, and modify the voltage-controlled oscillator capacitor array control signal cb when the control voltage is determined as outside the operation range. It should be understood that in some cases, the voltage-controlled oscillator capacitor array control signal cb that is directly found may be inaccurate. In these cases, the voltage-controlled oscillator capacitor array control signal cb is slightly modified, so that the control voltage of the voltage-controlled oscillator is within the operation range. The phase-locked monitoring circuit 4 receives the target voltage-controlled oscillator capacitor array control signal cb outputted by the calculation storage circuit 1 and the signal Vc outputted by the filter circuit 7, modifies the acquired target voltage-controlled oscillator capacitor array control signal cb based on the signal Vc to obtain a voltage-controlled oscillator capacitor array control signal cb', and outputs the voltage-controlled oscillator capacitor array control signal cb' to the selection circuit 11. As described above, the selection circuit 11 outputs the voltage-controlled oscillator capacitor array control signal cb' to the voltage-controlled oscillator 2, so that the voltage-controlled oscillator 2 outputs the frequency signal VOUT based on the signal cb' and the signal Vc.

The frequency divider 6 is configured to process the frequency signal VOUT outputted by the voltage-controlled oscillator 2, to acquire a processed signal, and outputs the processed signal to the phase-frequency detector 9. Further, since a frequency of the frequency signal VOUT is unnecessarily an integer multiple of a frequency of the processed signal, a modulator (for example, a sigma-delta modulator) 5 is added. The modulator 5 is configured to modulate a ratio of the frequency of the frequency signal VOUT to the frequency of the processed signal based on the target frequency control word signal FCW, so that the frequency divider 6 generates the ratio with a decimal.

The phase-frequency detector 9 receives the processed signal and the reference signal ref, and outputs a charge pump control signal based on the processed signal and the reference signal ref, so that the charge pump 8 outputs the signal Vc based on the charge pump current control signal ICP and the charge pump control signal.

Further, the phase-locked monitoring circuit 4 compares the signal Vc outputted by the charge pump with a first threshold and a second threshold. The first threshold is less than the second threshold. In response to a comparison result that the analog control signal is less than the first threshold, the voltage-controlled oscillator capacitor array control signal cb is modified in a predetermined direction. In response to a comparison result that the analog control signal is greater than the second threshold, the voltage-controlled oscillator capacitor array control signal cb is modified in a direction opposite to the predetermined direction. The predetermined direction depends on a property of the voltage-controlled oscillator. For example, the value of the voltage-controlled oscillator capacitor array control signal cb is increased and a frequency of an output signal of the voltage-controlled oscillator is decreased in a case that the signal Vc remains unchanged. The target voltage-controlled oscillator capacitor array control signal cb is modified as follows. In response to the comparison result that the signal Vc is less than the first threshold, the value of cb is decreased by 1. In response to the comparison result that the signal Vc is greater than the second threshold, the value of cb is increased by 1.

Further, the second bias voltage VL outputted by the bias voltage generation circuit serves as the first threshold, and the third bias voltage VH outputted by the bias voltage generation circuit serves as the second threshold.

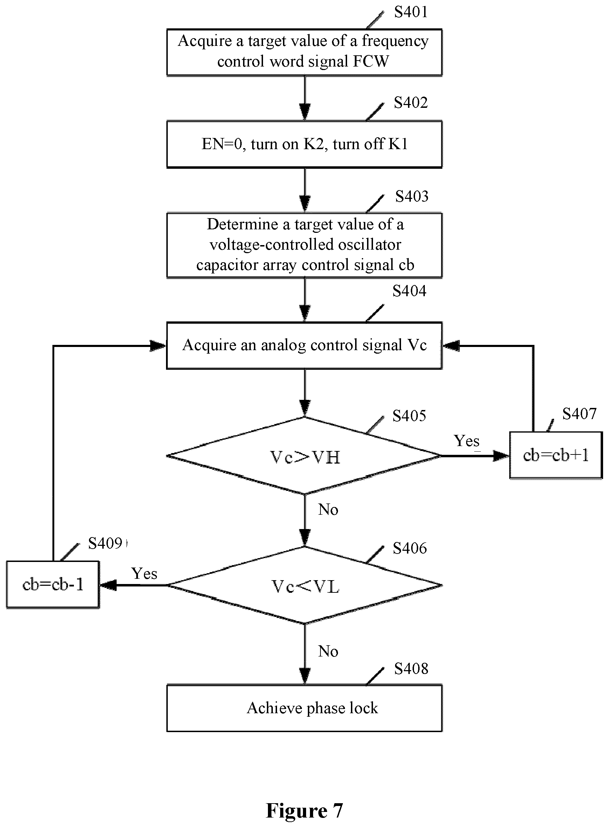

Referring to the flow chart illustrating the phase-locked mode shown in Figure 7, the phase-locked loop circuit achieves phase lock by performing the following steps S401 to S409.

In step S401, the target value of the frequency control word signal FCW is acquired.

The calculation and storage circuit 1 acquires the target value of the frequency control word signal. The frequency control word signal characterizes a ratio of the desired locked frequency to the frequency of the reference signal.

In step S402, the enable signal EN is set to 0, the second switch K2 is turned on and the first switch K1 is turned off.

The enable signal EN is set to 0, so that the selection circuit 11 outputs the output signal of the phase-locked monitoring circuit 4 to the voltage-controlled oscillator 2. In addition, the switch K2 is on and the switch K1 is off, so that the output signal of the charge pump 8 serves as the analog control signal of the voltage-controlled oscillator 2. Further, the output signal of the voltage-controlled oscillator 2 is fed back to the phase-frequency detector 9, to achieve feedback modification.

In step S403, the target value of the voltage-controlled oscillator capacitor array control signal cb is determined.

The calculation storage circuit 1 acquires the target value of the voltage-controlled oscillator capacitor array control signal cb corresponding to the target value of the frequency control word signal FCW based on the stored data, and determines the target value of the charge pump current control signal ICP corresponding to the target value of the voltage-controlled oscillator capacitor array control signal cb. The charge pump current control signal ICP is used to modify a current of the charge pump 8, so as to keep the loop bandwidth of the phase-locked loop circuit constant. In addition, the output signal of the voltage-controlled oscillator 2 depend on both the target voltage-controlled oscillator capacitor array control signal cb and the output signal of the charge pump.

In step S404, the signal Vc is acquired.

The phase-locked monitoring circuit 4 acquires the signal Vc outputted from the charge pump 8.

In step S405, the signal Vc is compared with the third bias voltage VH

The phase-locked monitoring circuit 4 compares the signal Vc and the third bias voltage VH

In response to a comparison result that the signal Vc is greater than the third bias voltage VH, step S407 is performed, that is, the value of the voltage-controlled oscillator capacitor array control signal cb is increased by one, so as to control the voltage-controlled oscillator 2.

In response to a comparison result that the signal Vc is not greater than the third bias voltage VH, step S406 is performed, that is, the signal Vc is compared with the second bias voltage VL.

In response to a comparison result that the signal Vc is less than the second bias voltage VL, step S409 is performed, that is, the value of the voltage-controlled oscillator capacitor array control signal cb is decreased by one, so as to control the voltage-controlled oscillator 2.

In response to a comparison result that the signal Vc is not less than the second bias voltage VL, step S408 is performed, that is, the phase lock is achieved.

In this way, for a given value of the frequency control word signal, a value of the voltage-controlled oscillator capacitor array control signal corresponding to the given value of the frequency control word signal and a value of the charge pump current control signal corresponding to the value of the voltage-controlled oscillator capacitor array control signal are acquired based on the stored data. The charge pump current control signal keeps the loop bandwidth constant. When the control voltage of the voltage-controlled oscillator under a current voltage-controlled oscillator capacitor array control signal is outside the operation range, the phase-locked monitoring circuit modifies the voltage-controlled oscillator capacitor array control signal (that is, the digital control signal of the voltage-controlled oscillator), so that the control voltage of the voltage-controlled oscillator is within the operation range. In addition, a feedback loop (including the frequency divider, the phase-frequency detector, the charge pump and the filter circuit) performs feedback modification on the output signal of the voltage-controlled oscillator.

In the embodiments of the present disclosure, multiple values of the voltage-controlled oscillator capacitor array control signal respectively corresponding to multiple desired values of the frequency control word signal and multiple values of the charge pump current control signal respectively corresponding to the multiple desired values of the frequency control word signal are acquired in the calibration mode. In the phase-locked mode, a target value of the voltage-controlled oscillator capacitor array control signal corresponding to a target value of the frequency control word signal and a target value of the charge pump current control signal corresponding to the target value of the voltage-controlled oscillator capacitor array control signal are determined based on the data acquired in the calibration mode, to control the phase-locked loop circuit to achieve the phase lock. Therefore, the optimal sub-band is directly determined based on the acquired data, thereby shortening the duration spent by the phase-locked loop circuit on achieving phase lock and reducing power consumption of the phase-locked loop circuit in the process of achieving phase lock.

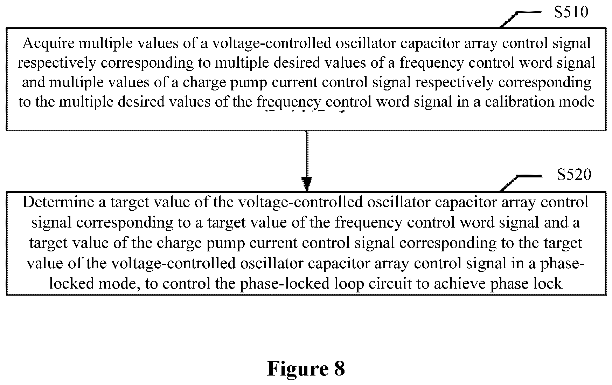

Figure 8 is a flow chart of a method for controlling the phase-locked loop circuit according to an embodiment of the present disclosure. As shown in Figure 8, the method for controlling the phase-locked loop circuit according to the embodiment of the present disclosure includes the following steps S510 and S520.

In step S510, in a calibration mode, multiple values of a voltage-controlled oscillator capacitor array control signal respectively corresponding to multiple desired values of a frequency control word signal and multiple values of a charge pump current control signal respectively corresponding to the multiple desired values of the frequency control word signal are acquired. The frequency control word signal characterizes a ratio of a desired locked frequency to a frequency of a reference signal.

In step S520, in a phase-locked mode, a target value of the voltage-controlled oscillator capacitor array control signal corresponding to a target value of the frequency control word signal and a target value of the charge pump current control signal corresponding to the target value of the frequency control word signal are determined, to control the phase-locked loop circuit to achieve phase lock.

In some embodiments, a voltage-controlled oscillator in the phase-locked loop circuit outputs a frequency signal based on an analog control signal and a digital control signal, to achieve the phase lock.

In some embodiments, the voltage-controlled oscillator capacitor array control signal serves as the digital control signal, to control total capacitance of a capacitor array in the voltage-controlled oscillator, so as to modify the frequency signal outputted by the voltage-controlled oscillator.

In some embodiments, in the calibration mode, a bias voltage generated by a bias voltage generation circuit serves as the analog control signal. In the phase-locked mode, an output signal of a charge pump in the phase-locked loop circuit serves as the analog control signal.

In some embodiments, the method further includes: in the calibration mode, storing a first correspondence between the multiple values of the frequency control word signal and the multiple values of the voltage-controlled oscillator capacitor array control signal, and storing a second correspondence between the multiple values of the voltage-controlled oscillator capacitor array control signal and the multiple values of the charge pump current control signal.

In some embodiments, the method further includes: in the phase-locked mode, searching the first correspondence for a value of the voltage-controlled oscillator capacitor array control signal corresponding to the target value of the frequency control word signal, and determining the found value of the voltage-controlled oscillator capacitor array control signal as the target value of the voltage-controlled oscillator capacitor array control signal; and searching the second correspondence for a value of the charge pump current control signal corresponding to the target value of the voltage-controlled oscillator capacitor array control signal, and determining the found value as the target value of the charge pump current control signal.

In some embodiments, the multiple values of the voltage-controlled oscillator capacitor array control signal respectively corresponding to the multiple desired values of the frequency control word signal are acquired by: determining a theoretical minimum value of the voltage-controlled oscillator capacitor array control signal based on a theoretical minimum value of the frequency control word signal; determining a theoretical maximum value of the voltage-controlled oscillator capacitor array control signal based on a theoretical maximum value of the frequency control word signal; and acquiring values of the voltage-controlled oscillator capacitor array control signal respectively corresponding to other values of the frequency control word signal than the theoretical minimum value and the theoretical maximum value of the frequency control word signal in a first interval. The first interval is between the theoretical minimum value and the theoretical maximum value of the frequency control word signal. An interval between the theoretical minimum value and theoretical maximum value of the voltage-controlled oscillator capacitor array control signal serves as a second interval.

In some embodiments, the determining a theoretical minimum value of the voltage-controlled oscillator capacitor array control signal based on a theoretical minimum value of the frequency control word signal includes: determining a current value of the voltage-controlled oscillator capacitor array control signal; outputting a frequency signal based on a first bias voltage generated by the bias voltage generation circuit and the voltage-controlled oscillator capacitor array control signal; converting the frequency signal into a digital frequency signal based on the reference signal; acquiring a first error based on a difference between the theoretical minimum value of the frequency control word signal and the digital frequency signal; estimating a current conversion gain; determining a second error based on the estimated conversion gain and the first error; determining the current value of the voltage-controlled oscillator capacitor array control signal as the theoretical minimum value of the voltage-controlled oscillator capacitor array control signal and storing the current value of the voltage-controlled oscillator capacitor array control signal in a case that the second error meets a predetermined condition; and modifying the voltage-controlled oscillator capacitor array control signal based on the first error in a case that the second error does not meet the predetermined condition.

In some embodiments, the determining a theoretical maximum value of the voltage-controlled oscillator capacitor array control signal based on a theoretical maximum value of the frequency control word signal includes: determining a current value of the voltage-controlled oscillator capacitor array control signal; outputting a frequency signal based on a first bias voltage generated by the bias voltage generation circuit and the voltage-controlled oscillator capacitor array control signal; converting the frequency signal into a digital frequency signal based on the reference signal; acquiring a first error based on a difference between the theoretical maximum value of the frequency control word signal and the digital frequency signal; estimating a current conversion gain; determining a second error based on the estimated conversion gain and the first error; determining the current value of the voltage-controlled oscillator capacitor array control signal as the theoretical maximum value of the voltage-controlled oscillator capacitor array control signal and storing the current value of the voltage-controlled oscillator capacitor array control signal in a case that the second error meets a predetermined condition; and modifying the voltage-controlled oscillator capacitor array control signal based on the first error in a case that the second error does not meet the predetermined condition.

In some embodiments, the estimating the current conversion gain includes: calculating the conversion gain based on a first difference and a second difference. The first difference is a difference between a current value of the digital frequency signal and a previous value of the digital frequency signal. The second difference is a difference between the current value of the voltage-controlled oscillator capacitor array control signal and a previous value of the voltage-controlled oscillator capacitor array control signal.

In some embodiments, the second error is acquired by multiplying a ratio of the first error to the conversion gain by the frequency of the reference signal.

In some embodiments, the predetermined condition is that an absolute value of the second error is less than 1.

In some embodiments, the modifying the voltage-controlled oscillator capacitor array control signal based on the first error includes: superimposing the current value of the voltage-controlled oscillator capacitor array control signal and the second error to obtain a next value of the voltage-controlled oscillator capacitor array control signal until the predetermined condition is met.

In some embodiments, the acquiring values of the voltage-controlled oscillator capacitor array control signal respectively corresponding to other values of the frequency control word signal in a first interval includes: selecting a value of the frequency control word signal within the first interval; outputting, for each of values of the voltage-controlled oscillator capacitor array control signal within the second interval, a frequency signal based on the first bias voltage generated by the bias voltage generation circuit and the value of the voltage-controlled oscillator capacitor array control signal; converting each of the outputted frequency signals into a digital frequency signal based on the reference signal; acquiring, for each of the digital frequency signals, a first error of the selected value of the frequency control word signal and the digital frequency signal; and determining a value of the voltage-controlled oscillator capacitor array control signal corresponding to a minimum among the first errors as a value of the voltage-controlled oscillator capacitor array control signal corresponding to the selected value of frequency control word signal, and storing the value of the voltage-controlled oscillator capacitor array control signal corresponding to the selected value of frequency control word signal.

In some embodiments, the multiple values of the charge pump current control signal respectively corresponding to the multiple desired values of the frequency control word signal are acquired by: selecting a value of the voltage-controlled oscillator capacitor array control signal within the second interval; outputting a second frequency signal based on the selected value of the voltage-controlled oscillator capacitor array control signal and a second bias voltage generated by the bias voltage generation circuit; converting the second frequency signal into a second digital frequency signal based on the reference signal; outputting a frequency signal based on the selected value of the voltage-controlled oscillator capacitor array control signal and a third bias voltage generated by the bias voltage generation circuit; converting the frequency signal into a third digital frequency signal based on the reference signal; determining a conversion gain based on the second digital frequency signal and the third digital frequency signal corresponding to the selected value of voltage-controlled oscillator capacitor array control signal; and determining the value of the charge pump current control signal corresponding to the selected value of the voltage-controlled oscillator capacitor array control signal based on the conversion gain, and storing the determined value of the charge pump current control signal.

In some embodiments, the conversion gain is acquired by multiplying a ratio of a third difference to a fourth difference by the frequency of the reference signal. The third difference is a difference between the second digital frequency signal and the third digital frequency signal corresponding to the selected value of the voltage-controlled oscillator capacitor array control signal. The fourth difference is a difference between the second bias voltage and the third bias voltage.

In some embodiments, the charge pump current control signal is used to compensate for a variation in a loop bandwidth resulted from a variation in the conversion gain of the voltage-controlled oscillator with different values of the voltage-controlled oscillator capacitor array control signal, so that the loop bandwidth is constant.

In some embodiments, the method further includes: processing, by a frequency divider, the frequency signal outputted by the voltage-controlled oscillator to acquire a processed signal; outputting a charge pump control signal based on the processed signal and the reference signal, for a charge pump to output the analog control signal based on the target value of the charge pump current control signal and the charge pump control signal; and filtering the analog control signal outputted by the charge pump.

In some embodiments, the method further includes: modifying the voltage-controlled oscillator capacitor array control signal based on the analog control signal; and outputting the modified voltage-controlled oscillator capacitor array control signal to the voltage-controlled oscillator.

In some embodiments, the modifying the voltage-controlled oscillator capacitor array control signal based on the analog control signal includes: comparing the analog control signal outputted by the charge pump with a first threshold and a second threshold, where the first threshold is less than the second threshold; modifying the voltage-controlled oscillator capacitor array control signal in a predetermined direction in response to a comparison result that the analog control signal is less than the first threshold; and modifying the target voltage-controlled oscillator capacitor array control signal in a direction opposite to the predetermined direction in response to a comparison result that the analog control signal is greater than the second threshold.

In some embodiments, the second bias voltage outputted by the bias voltage generation circuit serves as the first threshold, and the third bias voltage outputted by the bias voltage generation circuit serves as the second threshold.

In the embodiments of the present disclosure, multiple values of a voltage-controlled oscillator capacitor array control signal respectively corresponding to multiple desired values of a frequency control word signal and multiple values of a charge pump current control signal respectively corresponding to the multiple desired values of the frequency control word signal are acquired in the calibration mode. In the phase-locked mode, a target value of the voltage-controlled oscillator capacitor array control signal corresponding to a target value of the frequency control word signal and a target value of the charge pump current control signal corresponding to the target value of the voltage-controlled oscillator capacitor array control signal are determined based on the data acquired in the calibration mode, to control the phase-locked loop circuit to achieve the phase lock. Therefore, the optimal sub-band is directly determined based on the acquired data, thereby shortening the duration spent by the phase-locked loop circuit on achieving phase lock and reducing power consumption of the phase-locked loop circuit in the process of achieving phase lock.

Merely preferred embodiments of the present disclosure are described above and are not intended to limit the present disclosure. Those skilled in the art can make various modifications and variations to the present disclosure.

**Claims**

1. A method for controlling a phase-locked loop circuit, comprising:

  acquiring a plurality of values of a voltage-controlled oscillator capacitor array control signal respectively corresponding to a plurality of desired values of a frequency control word signal and acquiring a plurality of values of a charge pump current control signal respectively corresponding to the plurality of desired values of the frequency control word signal in a calibration mode, wherein the frequency control word signal characterizes a ratio of a desired locked frequency to a frequency of a reference signal; and determining a target value of the voltage-controlled oscillator capacitor array control signal corresponding to a target value of the frequency control word signal and a target value of the charge pump current control signal corresponding to the target value of the frequency control word signal in a phase-locked mode, to control the phase-locked loop circuit to achieve phase lock.

2. The method according to claim 1, wherein

the phase lock is achieved by outputting a frequency signal by a voltage-controlled oscillator in the phase-locked loop circuit based on an analog control signal and a digital control signal; and
the voltage-controlled oscillator capacitor array control signal serves as the digital control signal, for controlling total capacitance of a capacitor array in the voltage-controlled oscillator to modify the frequency signal outputted by the voltage-controlled oscillator; or
a bias voltage generated by a bias voltage generation circuit serves as the analog control signal in the calibration mode, and an output signal of a charge pump in the phase-locked loop circuit serves as the analog control signal in the phase-locked mode.

3. The method according to claim 1, further comprising: storing a first correspondence between the frequency control word signal and the voltage-controlled oscillator capacitor array control signal and a second correspondence between the voltage-controlled oscillator capacitor array control signal and the charge pump current control signal in the calibration mode.

4. The method according to claim 3, further comprising: searching the first correspondence for a value of the voltage-controlled oscillator capacitor array control signal corresponding to the target value of the frequency control word signal and determining the found value of the voltage-controlled oscillator capacitor array control signal as the target value of the voltage-controlled oscillator capacitor array control signal in the phase-locked mode.

5. The method according to claim 3, further comprising:

searching the second correspondence for a value of the charge pump current control signal corresponding to the target value of the voltage-controlled oscillator capacitor array control signal and determining the found value of the charge pump current control signal as the target value of the charge pump current control signal in the phase-locked mode.

6. The method according to claim 2, wherein the acquiring a plurality of values of a voltage-controlled oscillator capacitor array control signal respectively corresponding to a plurality of desired values of a frequency control word signal comprises:

determining a theoretical minimum value of the voltage-controlled oscillator capacitor array control signal based on a theoretical minimum value of the frequency control word signal; determining a theoretical maximum value of the voltage-controlled oscillator capacitor array control signal based on a theoretical maximum value of the frequency control word signal; and acquiring values of the voltage-controlled oscillator capacitor array control signal respectively corresponding to values of the frequency control word signal other than the theoretical minimum value and the theoretical maximum value of the frequency control word signal in a first interval, wherein the first interval is between the theoretical minimum value and the theoretical maximum value of the frequency control word signal, and an interval between the theoretical minimum value and the theoretical maximum value of the voltage-controlled oscillator capacitor array control signal serves as a second interval.

7. The method according to claim 6, wherein the determining a theoretical minimum value of the voltage-controlled oscillator capacitor array control signal based on a theoretical minimum value of the frequency control word signal comprises:

determining a current value of the voltage-controlled oscillator capacitor array control signal; outputting a frequency signal based on a first bias voltage generated by the bias voltage generation circuit and the voltage-controlled oscillator capacitor array control signal; converting the frequency signal into a digital frequency signal based on the reference signal; acquiring a first error based on a difference between the theoretical minimum value of the frequency control word signal and the digital frequency signal; estimating a current conversion gain; determining a second error based on the estimated conversion gain and the first error; determining the current value of the voltage-controlled oscillator capacitor array control signal as the theoretical minimum value of the voltage-controlled oscillator capacitor array control signal and storing the current value of the voltage-controlled oscillator capacitor array control signal in a case that the second error meets a predetermined condition; and

modifying the voltage-controlled oscillator capacitor array control signal based on the first error in a case that the second error does not meet the predetermined condition, wherein the predetermined condition is that an absolute value of the second error is less than 1.

8. The method according to claim 6, wherein the determining a theoretical maximum value of the voltage-controlled oscillator capacitor array control signal based on a theoretical maximum value of the frequency control word signal comprises:

determining a current value of the voltage-controlled oscillator capacitor array control signal;
outputting the frequency signal based on a first bias voltage generated by the bias voltage generation circuit and the voltage-controlled oscillator capacitor array control signal;
converting the frequency signal into a digital frequency signal based on the reference signal;
acquiring a first error based on a difference between the theoretical maximum value of the frequency control word signal and the digital frequency signal;
estimating a current conversion gain;
determining a second error based on the estimated conversion gain and the first error;
determining the current value of the voltage-controlled oscillator capacitor array control signal as the theoretical maximum value of the voltage-controlled oscillator capacitor array control signal and storing the current value of the voltage-controlled oscillator capacitor array control signal in a case that the second error meets a predetermined condition; and
modifying the voltage-controlled oscillator capacitor array control signal based on the first error in a case that the second error does not meet the predetermined condition, wherein the predetermined condition is that an absolute value of the second error is less than 1.

9. The method according to claim 7 or 8, wherein the estimating the current conversion gain comprises:
calculating the conversion gain based on a first difference and a second difference, wherein the first difference is a difference between a current value of the digital frequency signal and a previous value of the digital frequency signal, and the second difference is a difference between the current value of the voltage-controlled oscillator capacitor array control signal and a previous value of the voltage-controlled oscillator capacitor array control signal.

10. The method according to claim 7 or 8, wherein the second error is acquired by multiplying a ratio of the first error to the conversion gain by the frequency of the reference signal.

11. The method according to claim 7 or 8, wherein the modifying the voltage-controlled oscillator capacitor array control signal based on the first error comprises:
superimposing the current value of the voltage-controlled oscillator capacitor array control signal and the second error to obtain a next value of the voltage-controlled oscillator capacitor array control signal until the predetermined condition is met.

12. The method according to claim 6, wherein the acquiring values of the voltage-controlled oscillator capacitor array control signal respectively corresponding to values of the frequency control word signal other than the theoretical minimum value and the theoretical maximum value of the frequency control word signal in a first interval comprises:

selecting a value of the frequency control word signal within the first interval;
outputting, for each of values of the voltage-controlled oscillator capacitor array control signal within the second interval, a frequency signal based on the first bias voltage generated by the bias voltage generation circuit and the value of the voltage-controlled oscillator capacitor array control signal;
converting each of the outputted frequency signals into a digital frequency signal based on the reference signal;
acquiring, for each of the digital frequency signals, a first error of the selected value of the frequency control word signal and the digital frequency signal; and
determining a value of the voltage-controlled oscillator capacitor array control signal corresponding to a minimum among the first errors as a value of the voltage-controlled oscillator capacitor array control signal corresponding to the selected value of frequency control word signal, and storing the value of the voltage-controlled oscillator capacitor array control signal corresponding to the selected value of frequency control word signal.

13. The method according to claim 6, wherein the acquiring a plurality of values of a charge pump current control signal respectively corresponding to the plurality of desired values of the frequency control word signal comprises:

selecting a value of the voltage-controlled oscillator capacitor array control signal within the second interval;

outputting a second frequency signal based on the selected value of the voltage-controlled oscillator capacitor array control signal and a second bias voltage generated by the bias voltage generation circuit;

converting the second frequency signal into a second digital frequency signal based on the reference signal;

outputting a frequency signal based on the selected value of the voltage-controlled oscillator capacitor array control signal and a third bias voltage generated by the bias voltage generation circuit;

converting the frequency signal into a third digital frequency signal based on the reference signal;

determining a conversion gain based on the second digital frequency signal and the third digital frequency signal corresponding to the selected value of voltage-controlled oscillator capacitor array control signal; and

determining the value of the charge pump current control signal corresponding to the selected value of the voltage-controlled oscillator capacitor array control signal based on the conversion gain, and storing the determined value of the charge pump current control signal.

14. The method according to claim 13, wherein the conversion gain is acquired by multiplying a ratio of a third difference to a fourth difference by the frequency of the reference signal, wherein the third difference is a difference between the second digital frequency signal and the third digital frequency signal corresponding to the selected value of the voltage-controlled oscillator capacitor array control signal, and the fourth difference is a difference between the second bias voltage and the third bias voltage.

15. The method according to claim 13, wherein the charge pump current control signal is used to compensate for a variation in a loop bandwidth resulted from a variation in the conversion gain of the voltage-controlled oscillator with different values of the voltage-controlled oscillator capacitor array control signal, so that the loop bandwidth is constant.

16. The method according to claim 2, further comprising:

processing, by a frequency divider, the frequency signal outputted by the voltage-controlled oscillator to acquire a processed signal;

outputting a charge pump control signal based on the processed signal and the reference signal, for a charge pump to output the analog control signal based on the target value of the charge pump current control signal and the charge pump control signal; and

filtering the analog control signal outputted by the charge pump.

17. The method according to claim 2, further comprising:

modifying the voltage-controlled oscillator capacitor array control signal based on the analog control signal; and

outputting the modified voltage-controlled oscillator capacitor array control signal to the voltage-controlled oscillator.

18. The method according to claim 2, wherein the modifying the voltage-controlled oscillator capacitor array control signal based on the analog control signal comprises:

comparing the analog control signal outputted by the charge pump with a first threshold and a second threshold, wherein the first threshold is less than the second threshold;

modifying the voltage-controlled oscillator capacitor array control signal in a predetermined direction in response to a comparison result that the analog control signal is less than the first threshold; and

modifying the target voltage-controlled oscillator capacitor array control signal in a direction opposite to the predetermined direction in response to a comparison result that the analog control signal is greater than the second threshold.

19. The method according to claim 18, wherein a second bias voltage outputted by the bias voltage generation circuit serves as the first threshold, and a third bias voltage outputted by the bias voltage generation circuit serves as the second threshold.

20. A phase-locked loop circuit, comprising:

a charge pump;

a voltage-controlled oscillator; and

a calculation storage circuit configured to:

acquire a plurality of values of a voltage-controlled oscillator capacitor array control signal respectively corresponding to a plurality of desired values of a frequency control word signal and acquire a plurality of values of a charge pump current control signal respectively corresponding to the plurality of desired values of the frequency control word signal in a calibration mode, wherein the frequency control word signal characterizes a ratio of a desired locked frequency to a frequency of a reference signal; and

determine a target value of the voltage-controlled oscillator capacitor array control signal corresponding to a target value of the frequency control word signal and a target value of the charge pump current control signal corresponding to the target value of the frequency control word signal in a phase-locked mode, to control the phase-locked loop circuit to achieve phase lock.

21. The phase-locked loop circuit according to claim 20, wherein

the voltage-controlled oscillator is controlled based on an analog control signal and a digital control signal to output a frequency signal, so as to achieve phase-locked; and the voltage-controlled oscillator capacitor array control signal serves as the digital control signal, for controlling total capacitance of a capacitor array in the voltage-controlled oscillator to modify the frequency signal outputted by the voltage-controlled oscillator, wherein the phase-locked loop circuit further comprises: a bias voltage generation circuit configured to generate a bias voltage as the analog control signal of the voltage-controlled oscillator in the calibration mode, wherein an output signal of the charge pump serves as the analog control signal of the voltage-controlled oscillator in the phase-locked mode.

22. The phase-locked loop circuit according to claim 20, wherein the calculation storage circuit is further configured to store a first correspondence between the frequency control word signal and the voltage-controlled oscillator capacitor array control signal and a second correspondence between the voltage-controlled oscillator capacitor array control signal and the charge pump current control signal in the calibration mode.

23. The phase-locked loop circuit according to claim 22, wherein the calculation storage circuit is further configured to: search the first correspondence for a value of the voltage-controlled oscillator capacitor array control signal corresponding to the target value of the frequency control word signal; and determine the found value of the voltage-controlled oscillator capacitor array control signal as the target value of the voltage-controlled oscillator capacitor array control signal in the phase-locked mode.

24. The phase-locked loop circuit according to claim 22, wherein the calculation storage circuit is further configured to search the second correspondence for a value of the charge pump current control signal corresponding to the target value of the voltage-controlled oscillator capacitor array control signal and determine the found value of the charge pump current control signal as the target value of the charge pump current control signal in the phase-locked mode.

25. The phase-locked loop circuit according to claim 21, wherein

the calculation storage circuit is configured to, in order to acquire the plurality of values of the voltage-controlled oscillator capacitor array control signal respectively corresponding to the plurality of desired values of a frequency control word signal:

determine a theoretical minimum value of the voltage-controlled oscillator capacitor array control signal based on a theoretical minimum value of the frequency control word signal; determine a theoretical maximum value of the voltage-controlled oscillator capacitor array control signal based on a theoretical maximum value of the frequency control word signal; and acquire values of the voltage-controlled oscillator capacitor array control signal respectively corresponding to values of the frequency control word signal other than the theoretical minimum value and the theoretical maximum value of the frequency control word signal in a first interval, wherein the first interval is between the theoretical minimum value and the theoretical maximum value of the frequency control word signal, and an interval between the theoretical minimum value and the theoretical maximum value of the voltage-controlled oscillator capacitor array control signal serves as a second interval.

26. The phase-locked loop circuit according to claim 25, further comprising:
a frequency-to-digital converter configured to convert, based on the reference signal, the frequency signal outputted by the voltage-controlled oscillator into a digital frequency signal in the calibration mode.

27. The phase-locked loop circuit according to claim 26, wherein the calculation storage circuit is configured to, in order to determine the theoretical minimum value of the voltage-controlled oscillator capacitor array control signal:

determine a current value of the voltage-controlled oscillator capacitor array control signal; receive the digital frequency signal outputted by the frequency-to-digital converter, wherein the digital frequency signal is outputted based on the frequency signal outputted by the voltage-controlled oscillator, and the frequency signal is outputted based on a first bias voltage generated by the bias voltage generation circuit and the voltage-controlled oscillator capacitor array control signal;

acquire a first error based on a difference between the theoretical maximum value of the frequency control word signal and the digital frequency signal;

estimate a current conversion gain;

determine a second error based on the estimated conversion gain and the first error;

determine the current value of the voltage-controlled oscillator capacitor array control signal as the theoretical minimum value of the voltage-controlled oscillator capacitor array control signal and store the current value of the voltage-controlled oscillator capacitor array control signal in a case that the second error meets a predetermined condition; and

modify the voltage-controlled oscillator capacitor array control signal based on the first error in a case that the second error does not meet the predetermined condition.

28. The phase-locked loop circuit according to claim 26, wherein the calculation storage circuit is configured to, in order to determine the theoretical maximum value of the voltage-controlled oscillator capacitor array control signal:

determine a current value of the voltage-controlled oscillator capacitor array control signal;

receive the digital frequency signal outputted by the frequency-to-digital converter, wherein the digital frequency signal is outputted based on the frequency signal outputted by the voltage-controlled oscillator, and the frequency signal is outputted based on a first bias voltage generated by the bias voltage generation circuit and the voltage-controlled oscillator capacitor array control signal;

acquire a first error based on a difference between the theoretical maximum value of the frequency control word signal and the digital frequency signal;

estimate a current conversion gain;

determine a second error based on the estimated conversion gain and the first error;

determine the current value of the voltage-controlled oscillator capacitor array control signal as the theoretical maximum value of the voltage-controlled oscillator capacitor array control signal and store the current value of the voltage-controlled oscillator capacitor array control signal in a case that the second error meets a predetermined condition; and

modify the voltage-controlled oscillator capacitor array control signal based on the first error in a case that the second error does not meet the predetermined condition.

29. The phase-locked loop circuit according to claim 21, further comprising:

a frequency divider configured to process the frequency signal outputted by the voltage-controlled oscillator to acquire a processed signal;

a phase-frequency detector configured to output a charge pump control signal based on the processed signal and the reference signal, for the charge pump to output the analog control signal based on the target value of the charge pump current control signal and the charge pump control signal; and

a filter circuit configured to filter the analog control signal outputted by the charge pump.

30. The phase-locked loop circuit according to claim 29, further comprising:
a phase-locked monitoring circuit configured to: modify the voltage-controlled oscillator capacitor array control signal based on the analog control signal; and output the modified voltage-controlled oscillator capacitor array control signal.

31. The phase-locked loop circuit according to claim 30, further comprising:
a selection circuit configured to:

output the voltage-controlled oscillator capacitor array control signal from the calculation storage circuit to the voltage-controlled oscillator, to provide the digital control signal for the voltage-controlled oscillator in the calibration mode; and

output the voltage-controlled oscillator capacitor array control signal modified by the phase-locked monitoring circuit to the voltage-controlled oscillator, to provide the digital control signal for the voltage-controlled oscillator in the phase-locked mode.

**Figure 1**

FCW    ref

VOUT → Frequency-to-digital converter → DOUT → Calculation storage circuit → cb

10

1

Bias voltage generation circuit

3

Voltage-controlled oscillator → cb → (mux 1/0) 11

2

↓ VOUT    EN

**Figure 2**

**Figure 3**

**Figure 4**

S301

Select a value of cb within a second interval

S302

A bias voltage generation circuit outputs a VL, and a $DOUT_L$ is calculated

S303

The bias voltage generation circuit outputs a VH, and a $DOUT_H$ is calculated

S304

Calculate KVCO

S305

Calculate ICP and store the ICP

S306

$cb=cb_{max}$

No

Yes

S307

End

**Figure 5**

**Figure 6**

S401

Acquire a target value of a frequency control word signal FCW

S402

EN=0, turn on K2, turn off K1

S403

Determine a target value of a voltage-controlled oscillator capacitor array control signal cb

S404

Acquire an analog control signal Vc

S405

Vc>VH

Yes

S407

cb=cb+1

No

S409

cb=cb-1

Yes

S406

Vc<VL

No

S408

Achieve phase lock

**Figure 7**

S510

Acquire multiple values of a voltage-controlled oscillator capacitor array control signal respectively corresponding to multiple desired values of a frequency control word signal and multiple values of a charge pump current control signal respectively corresponding to the multiple desired values of the frequency control word signal in a calibration mode

S520

Determine a target value of the voltage-controlled oscillator capacitor array control signal corresponding to a target value of the frequency control word signal and a target value of the charge pump current control signal corresponding to the target value of the voltage-controlled oscillator capacitor array control signal in a phase-locked mode, to control the phase-locked loop circuit to achieve phase lock

**Figure 8**

Europäisches
Patentamt

European
Patent Office

Office européen
des brevets

## EUROPEAN SEARCH REPORT

**Application Number**

EP 22 18 7066

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 8 008 956 B1 (SHIN HYUNCHOL [KR] ET AL) 30 August 2011 (2011-08-30) | 1-17, 20-29 | INV. H03L7/087 |
| Y | * column 6, line 60 - column 8, line 4; figure 3 * <br> * column 8, line 5 - line 61; figure 4 * <br> * column 8, line 62 - column 11, line 44; figures 6,7 * | 18,19, 30,31 | H03L7/089 H03L7/099 H03L7/197 |
| X | US 8 674 771 B2 (DARABI HOOMAN [US]; BROADCOM CORP [US]) 18 March 2014 (2014-03-18) | 1,20 | |
| A | * column 6, line 4 - column 9, line 15; figures 3A,3B * | 2-19, 21-31 | |
| Y | US 2007/080751 A1 (TU YIH-MIN [TW] ET AL) 12 April 2007 (2007-04-12) <br> * paragraph [0033] - paragraph [0045]; figure 2 * <br> * paragraph [0046] - paragraph [0047]; figure 3 * <br> * paragraph [0048] - paragraph [0049]; figure 4 * <br> * paragraph [0050] - paragraph [0046]; figure 5 * | 18,19, 30,31 | |
| | | | **TECHNICAL FIELDS SEARCHED (IPC)** |
| A | US 2006/145769 A1 (VAANANEN PAAVO [FI] ET AL) 6 July 2006 (2006-07-06) <br> * paragraph [0037] - paragraph [0045]; figures 1,2 * | 1-31 | H03L |

The present search report has been drawn up for all claims

| Place of search | Date of completion of the search | Examiner |
|---|---|---|
| The Hague | 21 December 2022 | Aouichi, Mohamed |

EPO FORM 1503 03.82 (P04C01)

## ANNEX TO THE EUROPEAN SEARCH REPORT
## ON EUROPEAN PATENT APPLICATION NO.

EP 22 18 7066

This annex lists the patent family members relating to the patent documents cited in the above-mentioned European search report.
The members are as contained in the European Patent Office EDP file on
The European Patent Office is in no way liable for these particulars which are merely given for the purpose of information.

21-12-2022

| Patent document cited in search report | | Publication date | Patent family member(s) | | Publication date |
|---|---|---|---|---|---|
| US 8008956 | B1 | 30-08-2011 | NONE | | |
| US 8674771 | B2 | 18-03-2014 | NONE | | |
| US 2007080751 | A1 | 12-04-2007 | TW | I312613 B | 21-07-2009 |
| | | | US | 2007080751 A1 | 12-04-2007 |
| US 2006145769 | A1 | 06-07-2006 | CN | 101091316 A | 19-12-2007 |
| | | | EP | 1831999 A1 | 12-09-2007 |
| | | | KR | 20070086840 A | 27-08-2007 |
| | | | US | 2006145769 A1 | 06-07-2006 |
| | | | WO | 2006070224 A1 | 06-07-2006 |

EPO FORM P0459

For more details about this annex : see Official Journal of the European Patent Office, No. 12/82